(19) Europäisches Patentamt
European Patent Office
Office européen des brevets

(11) **EP 4 358 158 A1**

(12) **EUROPEAN PATENT APPLICATION**

(43) Date of publication:
**24.04.2024 Bulletin 2024/17**

(21) Application number: **23186559.3**

(22) Date of filing: **19.07.2023**

(51) International Patent Classification (IPC):
**H01L 31/107** *(2006.01)*

(52) Cooperative Patent Classification (CPC):
**H01L 31/1075**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.10.2022 EP 22306577**

(71) Applicant: **Viavi Solutions Inc.**
**Chandler, AZ 85286 (US)**

(72) Inventor: **VERDUN, Michael**
**42170 Saint-Just-Saint-Rambert (FR)**

(74) Representative: **Murgitroyd & Company**
**165-169 Scotland Street**
**Glasgow G5 8PL (GB)**

(54) **PHOTODIODE SEMICONDUCTOR STACKS WITH REDUCED RECOVERY TIMES**

(57) In some examples, a photodiode semiconductor stack may include an absorption layer and a photon trap layer. The photon trap layer is positioned with respect to the absorption layer to absorb at least some photons that are not absorbed in the absorption layer, which may reduce a number of times that multiple photons make round trips in the photodiode semiconductor stack without generating more photocurrent. The recovery time of the photodiode semiconductor stack may be reduced through the decrease in the number of times that the multiple photons make the round trips in the photodiode semiconductor stack.

**EP 4 358 158 A1**

**Description**

BACKGROUND

An avalanche photodiode (APD), which may also be referenced as a semiconductor photodiode detector, converts light into electricity by utilizing the photoelectric effect. APDs often include a relatively high sensitivity and a relatively high internal gain. Additionally, APDs are often used in fiber optic communication systems as photodetectors.

SUMMARY

According to an aspect of the present disclosure there is provided a photodiode semiconductor stack comprising:

an absorption layer; and

a photon trap layer positioned with respect to the absorption layer to absorb at least some photons that are not absorbed in the absorption layer.

The photon trap layer may be doped to cause photon carriers to be recombined in the photon trap layer. The photon trap layer may be to reduce a number of times that multiple photons make round trips in the photodiode semiconductor stack. Thee photon trap layer may be formed of a common material as the absorption layer. The photodiode semiconductor stack may further comprise: a p-doped semiconductor area, wherein light is to enter into the photodiode semiconductor stack through the p-doped semiconductor area. The photodiode semiconductor stack may further comprise: a doped layer positioned between the photon trap layer and the absorption layer, wherein the doped layer is to avoid diffusion of carriers from the photon trap layer to the absorption layer. The photodiode semiconductor may further comprise: a substrate, wherein the photon trap layer is positioned between the doped layer and the substrate. The photodiode semiconductor stack may, further comprise: a substrate, wherein the substrate is positioned between the photon trap layer and the absorption layer.

According to another aspect of the present disclosure there is provided a photodiode module comprising: a p-doped semiconductor area, wherein light is to be received into the photodiode module through the p-doped semiconductor area; an absorption layer; and a photon trap layer, the absorption layer being positioned between the p-doped semiconductor area and the photon trap layer, the photon trap layer to absorb at least some photons from the light that the absorption layer does not absorb to reduce a recovery time of the photodiode module.

The photon trap layer may be doped to cause photon carriers to be recombined in the photon trap layer. The photon trap layer may be to reduce a number of times that multiple photons make round trips in the photodiode semiconductor stack. The photon trap layer may be formed of a common material as the absorption layer. The photodiode module may further comprise: a doped layer positioned between the photon trap layer and the absorption layer, wherein the doped layer is to avoid diffusion of carriers from the photon trap layer to the absorption layer. The photodiode module may, further comprise: a substrate, wherein the photon trap layer is positioned between the substrate and the absorption layer. The photodiode module may further comprise: a substrate positioned between the photon trap layer and the absorption layer.

According to a yet further aspect of the present disclosure there is provided a photodiode module comprising: a front side illuminated avalanche photodiode semiconductor structure having an absorption layer; and a photon trap layer positioned with respect to the front side illuminated avalanche photodiode semiconductor structure to reduce a recovery time of the photodiode module.

The photon trap layer may have a thickness that is higher than a carrier diffusion length of the photon trap layer. The photon trap layer may be formed of a common material as the absorption layer. The photodiode module may further comprise: a substrate, wherein the photon trap layer is positioned between the substrate and the front side illuminated avalanche photodiode semiconductor structure. The photodiode module may further comprise: a substrate positioned between the photon trap layer and the front side illuminated avalanche photodiode semiconductor structure.

BRIEF DESCRIPTION OF DRAWINGS

Features of the present disclosure are illustrated by way of example and not limited in the following figure(s), in which like numerals indicate like elements, in which:

Figure 1 illustrates a cross-sectional diagram of a conventional avalanche photodiode (APD);

Figure 2 illustrates a diagram of a photodiode semiconductor stack, in accordance with an example of the present disclosure;

Figure 3 illustrates a diagram of a graph that shows correlation between the thickness of an indium gallium arsenide (InGaAs) layer, e.g., a photon trap layer, and quantum efficiency at 1550 nm, in accordance with an example of the present disclosure;

Figure 4 illustrates a diagram of a further photodiode semiconductor stack, in accordance with an example of the present disclosure; and

Figure 5 illustrates a diagram of a photodiode module, in accordance with an example of the present disclosure.

DETAILED DESCRIPTION

For simplicity and illustrative purposes, the present disclosure is described by referring mainly to examples. In the following description, numerous specific details are set forth in order to provide a thorough understanding of the present disclosure. It will be readily apparent however, that the present disclosure may be practiced without limitation to these specific details. In other instances, some methods and structures have not been described in detail so as not to unnecessarily obscure the present disclosure.

Throughout the present disclosure, the terms "a" and "an" are intended to denote at least one of a particular element. As used herein, the term "includes" means includes but not limited to, the term "including" means including but not limited to. The term "based on" means based at least in part on. The term "optical fiber" may be generalized to an optical waveguide of any type.

An optical time-domain reflectometer (OTDR) device is an optoelectronic instrument used to characterize an optical fiber. An OTDR device injects a series of optical pulses into an optical fiber under test through a wavelength division multiplexing (WDM) component in order to test and monitor a network. Based on the injected optical pulses, the OTDR device may extract, from the same end of the optical fiber in which the optical pulses are injected, light that is scattered or reflected back from points along the optical fiber. The scattered or reflected light that is gathered back is used to characterize the optical fiber. For example, the scattered or reflected light that is gathered back is used to detect, locate, and measure events at any location of the optical fiber. The events may include faults at any location of the optical fiber. Other types of features that the OTDR device may measure include attenuation uniformity and attenuation rate, segment length, bends, fiber end, and location and insertion loss of connectors, splices, or any other optical components such as splitters or multiplexers.

In reflectometry, low levels of light (e.g., Rayleigh scattering) may need to be adequately measured immediately after occurrence of events such as Fresnel reflections or splitters on an optical probe pulse along an optical fiber under test. The light may need to be measured immediately after the occurrence of the events to avoid too long of a "dead zone," which is one of the main specifications of an OTDR device. In addition, because of the low level of the Rayleigh scattering, a high gain and low noise avalanche photodiode (APD), e.g., an APD with high sensitivity, is often needed to adequately measure the light.

In many instances, the wavelengths of interest are mainly located in the short wavelength infrared range (typically between around 1300 nm and around 1650 nm). Thus, the absorption layer of the semiconductor of the APD may need to have a small energy bandgap, e.g., a wavelength cutoff higher than around 1650 nm. By way of particular example, indium gallium arsenide (InGaAs) is a semiconductor used as an absorption layer for APDs, which has a relatively small energy bandgap. As a result, the use of an InGaAs semiconductor in an APD may lead to a poor level of noise. In many instances, heterojunctions and localized p-doped layers are used to provide high levels of sensitivity.

A high bandgap energy p-doped semiconductor with a smaller area than the absorption layer area is defined as the active area of the semi-conductor structure (the high electric field area). Particularly this helps to have no electric field at the edge of the InGaAs layer where defects in the semiconductor could lead to noise if localized in the high electric field region.

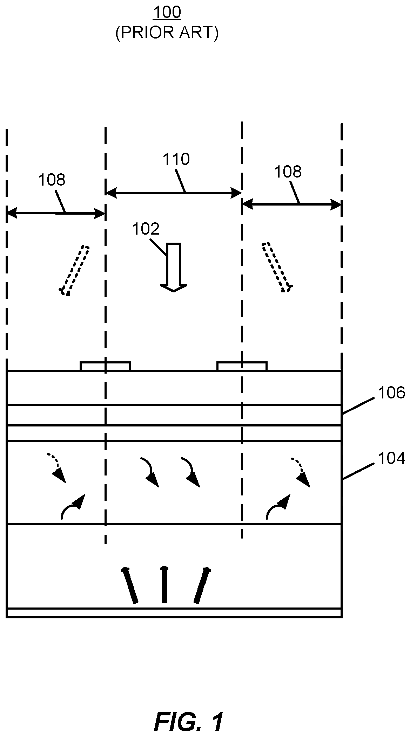

A drawback of these low noise structures is that they can lead to a relatively long recovery time. To illustrate the relatively long recovery time of certain APD structures, reference is made to Figure 1, which shows a cross-sectional diagram of a conventional APD 100. The APD 100 in Figure 1 shows the principle of the absorption of photons 102 in a front side illuminated InGaAs APD semiconductor structure. As shown, photons 102 are absorbed in the active absorption layer 104, which may be made of InGaAs, and dissociated into electron and hole carriers. Those last carriers are multiplied in the multiplication layer 106, which may be made of indium phosphide (InP), to give rise to an internal gain. In the example of Figure 1, the active absorption layer 104 is delimited by a localized p-doped region (so-called planar structure).

The recovery time T_total of the APD shown in Figure 1 generally comes from three main time responses T_BW, T_LEF, and T_NDA as denoted by the following equation:

Equation (1): $T\_total = T\_BW + T\_LEF + T\_NDA$.

T_BW is an intrinsic time response of the APD 100 and may mainly be related to the bandwidth of the APD 100. This time response may be made to be negligible compared to the other two time responses by selecting an APD 100 with a sufficiently high bandwidth, e.g., a few GHz.

T_LEF is a time response of the photons that are directly absorbed in low electric field areas 108 (or at the edge of high electric field area 110). This time response may be important for a large beam compared to the high electric field area 110 or for beams with optical aberrations.

T_NDA is a time response of the photons that go through the high electric field area 110 but are not directly absorbed. For example, an InGaAs APD 100 may have a typical absorption efficiency of about 85% at 1550 nm and thus 15% of the photons are not directly absorbed. Instead, those photons are reflected or backscattered by the backside of the APD 100 to partly go into the low electric field areas 108.

Disclosed herein are photodiode semiconductor stacks and photodiode modules that include a photon trap layer that is to absorb at least some photons that are not absorbed in an absorption layer of a photodiode semiconductor stack or photodiode module. As discussed herein, the photon trap layer may reduce the number of times that multiple photons make round trips in the photodiode semiconductor stacks without generating more photocurrent. As a result, an absorption efficiency of the photon trap layer may be improved. As also discussed herein, the increase in the absorption efficiency of the photon trap layer results in a reduction, e.g., improvement, in the recovery time of the photodiode semiconductor stacks and photodiode modules disclosed herein. Particularly, for instance, the photodiode semiconductor stacks and photodiode modules disclosed herein may include structures that reduce the T_NDA response time.

In one regard, through inclusion of the photon trap layer in the photodiode semiconductor stacks and photodiode modules, the thickness of the layers that absorb photons is increased without increasing the thickness of the absorption layer. As a result, drawbacks associated with increasing the thickness of the absorption layer, such as an increased fabrication process time due to the growth rate of the absorption layer, may be obviated. In addition, in some examples, the photon trap layer may be fabricated on a substrate prior to formation of a photodiode semiconductor structure on the substrate. This may also reduce or optimize fabrication times of the photodiode semiconductor stacks as the photon trap layer may not need to be formed with the formation of the photodiode semiconductor structure.

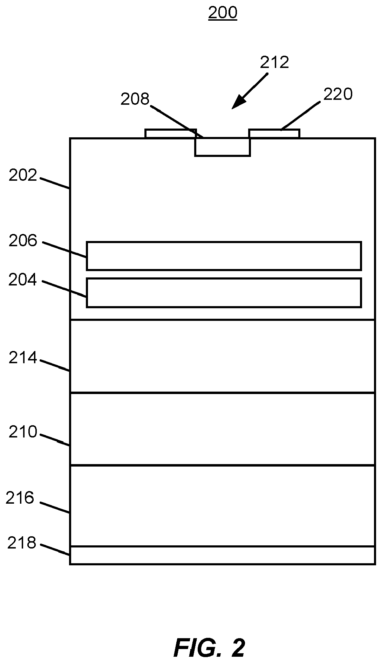

Reference is now made to Figure 2, which illustrates a diagram of a photodiode semiconductor stack 200, in accordance with an example of the present disclosure. The photodiode semiconductor stack 200 may also be termed a photodiode module 200 and/or the photodiode module 200 may be construed as including a photodiode semiconductor stack 200. In some examples, the photodiode semiconductor stack 200 is an avalanche photodiode (APD) and particularly, a front side illuminated APD.

The photodiode semiconductor stack 200 is depicted in Figure 2 as including an avalanche photodiode semiconductor structure 202, which includes an absorption layer 204. The avalanche photodiode semiconductor structure 202 may also include a multiplication layer 206 and a p-doped semiconductor area 208. Although the multiplication layer 206 is depicted as being positioned between the absorption layer 204 and the p-doped semiconductor area 208, it should be understood that the absorption layer 204 may be positioned between the p-doped semiconductor area 208 and the multiplication layer 206 in some examples.

According to examples, the photodiode semiconductor stack 200 is a front side illuminated avalanche photodiode chip having a heterojunction structure with a high bandgap energy p-doped semiconductor area 208 that is smaller than the absorption layer 204. In any regard, the photodiode semiconductor stack 200 may receive light through the p-doped semiconductor area 208 and into the avalanche photodiode semiconductor structure 202.

According to examples, the multiplication layer 206 is made of InP and the absorption layer 204 is made of InGaAs. In addition, photons that enter into the photodiode semiconductor stack 200 are dissociated in the absorption layer 204 into electron and hole carriers. The last carriers are multiplied in the multiplication layer 206 to give rise to an internal gain within the photodiode semiconductor stack 200.

As shown in Figure 2, the photodiode semiconductor stack 200 also includes a photon trap layer 210. The photon trap layer 210 is depicted as being positioned such that the avalanche photodiode semiconductor structure 202 is positioned between a front side 212 of the photodiode semiconductor stack 200 and the photon trap layer 210. In other words, the photon trap layer 210 may be positioned with respect to the absorption layer 204 to absorb at least some photons that are not absorbed in the absorption layer 204. According to examples, the photon trap layer 210 is configured to trap photons that are not directly absorbed by the absorption layer 204. In some examples, the photon trap layer 210 is made of a same material as the absorption layer 204. In other examples, such as when the photon trap layer 210 is formed beneath the substrate 216, the photon trap layer 210 is made of a different type of absorbing material such as germanium. In some examples, the photon trap layer 210 may be formed of an electrically conductive material.

In any of these examples, the photon trap layer 210 may be highly doped to ensure a sufficient level of electrical conductivity and to also allow the carriers in the photon trap layer 210 to be quickly recombined. By way of particular example, the photon trap layer 210 has a doping concentration that is typically greater than about $1.10^{18}$ cm$^{-3}$. The photon trap layer 210 may also have a thickness of about at least a few hundred nanometers. The photon trap layer 210 may have this thickness in examples in which the photon trap layer 210 is made of InGaAs to have a significant impact on the quantum efficiency of the photodiode semiconductor stack 200 over a wavelength of interest. By way of example, the wavelength of interest may be 1310 nm, 1550 nm, 1625 nm, 1650 nm, or other wavelength that is related to telecom or datacom networks. The wavelength of interest may be defined as a median wavelength of light that the absorption layer 204 is to absorb.

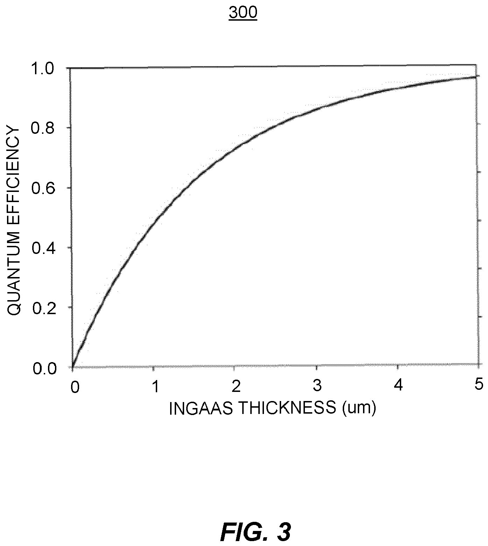

Turning now to Figure 3, there is shown a diagram of a graph 300 that shows the correlation between the thickness of an InGaAs layer, e.g., the photon trap layer 210, and the quantum efficiency at 1550 nm of the InGaAs layer, according to an example of the present disclosure. As shown in the graph 300, the quantum efficiency of the InGaAs layer, e.g., at 1550 nm, increases as a function of the thickness of the InGaAs layer. As shown in the graph 300, in order to absorb at least a few percentage, e.g., around 10%, of the remaining photons, the thickness of the photon trap layer 210, e.g., which is formed of InGaAs, is at least a few hundred nanometers.

With reference back to Figure 2, the photodiode semiconductor stack 200 is also depicted as including a doped layer 214. The doped layer 214, which may be formed of InP n+, is to avoid diffusion of carriers from the photon trap layer 210 to the absorption layer 204. The doped layer 214 may be a highly doped layer and may be transparent, e.g., at the wavelength of interest. By way of particular example, the doped layer 214 has a doping concentration that is greater than about $1.10^{18}$ cm$^{-3}$. The doped layer 214 may also have a thickness that is higher than the carrier diffusion length, which depends on the doping level of the doped layer 214. For instance, the doped layer 214 may have a thickness that is about at least a few hundred nanometers. Although the doped layer 214 and the photon trap layer 210 are depicted in Figure 2 as being positioned directly beneath the avalanche photodiode semiconductor structure 202, other layers may be provided between the avalanche photodiode semiconductor structure 202, the doped layer 214, and/or the photon trap layer 210.

In addition, the photodiode semiconductor stack 200 is depicted as including a substrate 216 positioned beneath the photon trap layer 210. The substrate 216 may be an InP substrate and may be the material on which the avalanche photodiode semiconductor structure 202, e.g., epitaxial stack, may be grown. The photodiode semiconductor stack 200 is further depicted as including a cathode 218 and an anode 220. In some examples, electrical energy converted in the photodiode semiconductor stack 200 may be outputted from the photodiode semiconductor stack 200 through the anode 220 and the cathode 218.

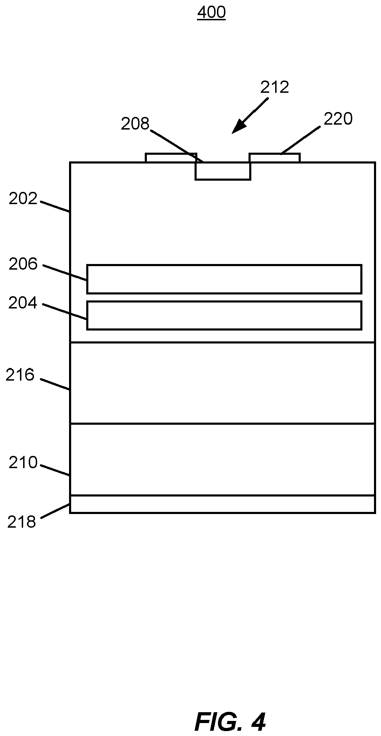

Reference is now made to Figure 4, which illustrates a diagram of a further photodiode semiconductor stack 400, in accordance with an example of the present disclosure. The photodiode semiconductor stack 400 includes the same components as the photodiode semiconductor stack 200 depicted in Figure 2. However, in the photodiode semiconductor stack 400 depicted in Figure 4, the photon trap layer 210 is positioned beneath the substrate 216. In other words, the substrate 216 is positioned between the photon trap layer 210 and the avalanche photodiode semiconductor structure 202. In these examples, the photon trap layer 210 may be formed of the same material as the absorption layer 204. In addition, the doped layer 214 included in the photodiode semiconductor stack 200 depicted in Figure 2 may be omitted from the photodiode semiconductor stack 400.

In the photodiode semiconductor stack 400, the photon trap layer 210 may be formed of a material that differs from the photon trap layer 210 included in the photodiode semiconductor stack 200. For instance, the photon trap layer 210 may be formed of a material other than InGaAs, such as germanium.

In some examples, the photon trap layer 210 may be formed on the substrate 216 prior to the formation of the avalanche photodiode semiconductor structure 202. In some examples, the photon trap layer 210 may be grown on a surface of the substrate 216 on which the avalanche photodiode semiconductor structure 202. In other examples, the photon trap layer 210 may be grown on a surface of the substrate 216 that is opposite the surface on which the avalanche photodiode semiconductor structure 202 is to be grown. In either of these examples, a manufacturer of the substrate 216 and the photon trap layer 210 may be separate from a manufacturer of the avalanche photodiode semiconductor structure 202 on the substrate 216.

In some examples, therefore, the fabrication process of the avalanche photodiode semiconductor structure 202 on the substrate 216 may not need to be modified. Instead, the avalanche photodiode semiconductor structure 202 may be grown on the substrate 216 or on the photon trap layer 210. As a result, the length of time required to grow the avalanche photodiode semiconductor structure 202 may not be affected by the growth of the photon trap layer 210 on substrate 216. However, in some examples, the photon trap layer 210 may be grown on the substrate 216 as part of the process of growing the avalanche photodiode semiconductor structure 202, for instance, by an epitaxial process.

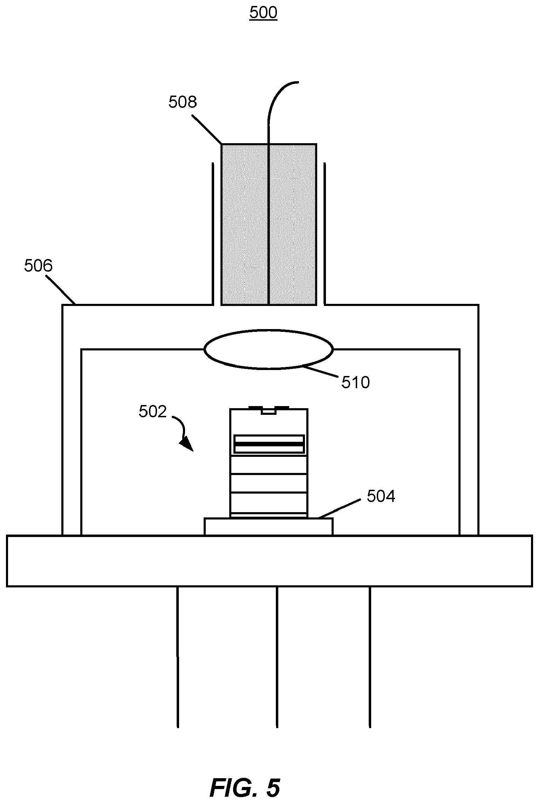

Reference is now made to Figure 5, which shows a diagram of a photodiode module 500, in accordance with an example of the present disclosure. As shown, the photodiode module 500 includes a photodiode semiconductor stack 502, which, in some examples, is an avalanche photodiode semiconductor structure. The photodiode semiconductor stack 502 may be equivalent to either of the photodiode semiconductor stacks 200 and 400 discussed herein with respect to Figures 2 and 4, respectively. In this regard, the photodiode semiconductor stack 502 includes a multiplication layer 206, an absorption layer 204, and a photon trap layer 210. The photodiode semiconductor stack 502 may also include some or all of the additional components discussed herein.

As shown in Figure 5, the photodiode semiconductor stack 502 may be positioned on a submount 504. The submount 504 may be formed of a thermally non-conductive material, such as a ceramic material like alumina and/or the like. The photodiode semiconductor stack 502 may be adhered to the submount 504 through use of an adhesive, welding, and/or the like, or may be mounted to the submount 504 via a mechanical fastener.

The photodiode semiconductor stack 502 and the submount 504 are depicted as being enclosed within a fiber pigtailed package 506. For instance, the fiber pigtailed package 506 is a TO-can pigtailed package.

The fiber pigtailed package 506 is depicted as positioning an end of a fiber 508 near a front side of the photodiode semiconductor stack 502. The fiber pigtailed package 506 is also depicted as including a lens 510 or other optical device that may direct light from the fiber 508 onto the front side of the photodiode semiconductor stack 502. According to examples, the fiber pigtailed package 506 may butt-couple the fiber 508, which may be an optical fiber, to the photodiode semiconductor stack 502.

What has been described and illustrated herein is an example along with some of its variations. The terms, descriptions and figures used herein are set forth by way of illustration only and are not meant as limitations. Many variations are possible within the spirit and scope of the subject matter, which is intended to be defined by the following claims -- and their equivalents -- in which all terms are meant in their broadest reasonable sense unless otherwise indicated.

**Claims**

1. A photodiode semiconductor stack comprising:

   an absorption layer; and
   a photon trap layer positioned with respect to the absorption layer to absorb at least some photons that are not absorbed in the absorption layer.

2. The photodiode semiconductor stack of claim 1, wherein the photon trap layer is to reduce a number of times that multiple photons make round trips in the photodiode semiconductor stack.

3. The photodiode semiconductor stack of claim 1, further comprising:
   a p-doped semiconductor area, wherein light is to enter into the photodiode semiconductor stack through the p-doped semiconductor area.

4. The photodiode semiconductor stack of claim 3, further comprising:
   a substrate, wherein the photon trap layer is positioned between the doped layer and the substrate.

5. The photodiode semiconductor stack of claim 1, further comprising:
   a substrate, wherein the substrate is positioned between the photon trap layer and the absorption layer.

6. A photodiode module comprising:

   a p-doped semiconductor area, wherein light is to be received into the photodiode module through the p-doped semiconductor area;
   an absorption layer; and
   a photon trap layer, the absorption layer being positioned between the p-doped semiconductor area and the photon trap layer, the photon trap layer to absorb at least some photons from the light that the absorption layer does not absorb to reduce a recovery time of the photodiode module.

7. The photodiode module of claim 6, wherein the photon trap layer is to reduce a number of times that multiple photons make round trips in the photodiode semiconductor stack.

8. The photodiode semiconductor stack of claim 1 or the photodiode module of claim 6, further comprising:
   a doped layer positioned between the photon trap layer and the absorption layer, wherein the doped layer is to avoid diffusion of carriers from the photon trap layer to the absorption layer.

9. The photodiode module of claim 8, further comprising:

a substrate, wherein the photon trap layer is positioned between the substrate and the absorption layer.

10. The photodiode semiconductor stack of claim 1 or the photodiode module of claim 6, wherein the photon trap layer is doped to cause photon carriers to be recombined in the photon trap layer.

11. A photodiode module comprising:

a front side illuminated avalanche photodiode semiconductor structure having an absorption layer; and
a photon trap layer positioned with respect to the front side illuminated avalanche photodiode semiconductor structure to reduce a recovery time of the photodiode module.

12. The photodiode module of claim 11, wherein the photon trap layer has a thickness that is higher than a carrier diffusion length of the photon trap layer.

13. The photodiode module of claim 11, further comprising:
a substrate, wherein the photon trap layer is positioned between the substrate and the front side illuminated avalanche photodiode semiconductor structure.

14. The photodiode module of claim 11, further comprising:
a substrate positioned between the photon trap layer and the front side illuminated avalanche photodiode semiconductor structure.

15. The photodiode semiconductor stack of claim 1 or the photodiode module of either claim 6, or claim 11, wherein the photon trap layer is formed of a common material as the absorption layer.

100
(PRIOR ART)

**FIG. 1**

200

212

208

220

202

206

204

214

210

216

218

**FIG. 2**

<u>300</u>

FIG. 3

400

**FIG. 4**

**FIG. 5**

Europäisches
Patentamt

European
Patent Office

Office européen
des brevets

## EUROPEAN SEARCH REPORT

Application Number

EP 23 18 6559

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 590 350 A (INTEGRATED COMPOUND SEMICONDUCTORS LTD [GB]) 30 June 2021 (2021-06-30) | 1-4, 6-13,15 | INV. H01L31/107 |
| A | * the whole document * | 5,14 | |
| X | WO 2021/099769 A2 (UNIV SHEFFIELD [GB]) 27 May 2021 (2021-05-27) | 1-4, 6-13,15 | |
| A | * the whole document * | 5,14 | |
| X | JOHN M HAYES ET AL: "Modeling the effects of interface traps on passive quenching of a Ge/Si geiger mode avalanche photodiode", OPTICAL AND QUANTUM ELECTRONICS, KLUWER ACADEMIC PUBLISHERS, BO, vol. 44, no. 3 - 5, 7 January 2012 (2012-01-07), pages 119-124, XP035063013, ISSN: 1572-817X, DOI: 10.1007/S11082-011-9533-0 * the whole document * | 1-15 | |

**TECHNICAL FIELDS SEARCHED (IPC)**

H01L

The present search report has been drawn up for all claims

| Place of search | Date of completion of the search | Examiner |
|---|---|---|
| Berlin | 20 February 2024 | Voignier, Vincent |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.............................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

**EP 23 18 6559**

This annex lists the patent family members relating to the patent documents cited in the above-mentioned European search report.
The members are as contained in the European Patent Office EDP file on
The European Patent Office is in no way liable for these particulars which are merely given for the purpose of information.

**20-02-2024**

| Patent document cited in search report | | Publication date | Patent family member(s) | | Publication date |
|---|---|---|---|---|---|
| GB 2590350 | A | 30-06-2021 | NONE | | |
| WO 2021099769 | A2 | 27-05-2021 | EP | 4062458 A2 | 28-09-2022 |
| | | | GB | 2591320 A | 28-07-2021 |
| | | | GB | 2602731 A | 13-07-2022 |
| | | | US | 2022416110 A1 | 29-12-2022 |
| | | | WO | 2021099769 A2 | 27-05-2021 |

EPO FORM P0459

For more details about this annex : see Official Journal of the European Patent Office, No. 12/82